# EUROPEAN PATENT APPLICATION

(11) **EP 3 246 714 A1**
(43) Date of publication of application: **22.11.2017**
(21) Application number: 16169923.6
(22) Date of filing: 17.05.2016
(51) Int. Cl.: G01R 22/06, H02M 7/42, G01R 31/42

(54) **INVERTER HAVING A REVENUE GRADE METER**

(71) Applicant: ABB Schweiz AG, 5400 Baden (CH)
(72) Inventor: FIACCHINI, Gabriele, 52024 San Giovanni Valdarno (AR) (IT); MACERINI, Sauro, 52021 Levane - Bucine (AR) (IT)
(74) Representative: Mannucci, Michele

(57) **Abstract**

An inverter is described, for use e.g. in connection with photovoltaic panels or another renewable energy resource. The inverter comprises:
- an input for connection to an electric power source (1.1; 1.2; 1.2; 3);
- grid connectors (11) for connection to an electric power distribution grid (7);
- a metering device (21) functionally coupled to a sensing circuitry (17) arranged for sensing at least one electric parameter at the grid connectors (11) and configured for measuring said at least one electric parameter;

The metering device (21) is integrated with a data transmission arrangement (23).

## Description

### Technical field

The invention generally relates to inverters. Embodiments disclosed herein more specifically concern inverters designed for connecting a DC electric power source to an AC electric distribution grid, wherein the DC electric power source is a resource of renewable energy, e.g. a system of photovoltaic panels.

### Background art

Recently, the use of alternative energy sources, such as so-called renewable energy sources, have been investigated, in order to reduce the cost and environmental impact of traditional power production technologies based on the use of fossil fuels, and atomic energy.

Among others, solar energy is one of the most promising renewable resources for the production of electric energy. Conversion of solar power into electric power can be through thermodynamic cycles, whereby solar thermal energy collected and concentrated by mirrors, is converted into mechanical power to drive electric generators, which in turn convert the mechanical power into useful electric power. Alternatively, electric power can be obtained through direct conversion of solar radiating power into electric power through photovoltaic panels (shortly PV panels). Photovoltaic panels generate DC electric current, which must be converted into AC electric current at required grid voltage and grid frequency for powering loads or distribution on electric power distribution grids. Conversion of the Dc current is obtained by means of inverters.

Power produced by a PV panel system can be partly used to power local loads, e.g. domestic electric appliances, and partly delivered to an external electric power distribution grid, connected to the inverter. When the electric power delivered by the inverter exceeds the amount of power required by the local loads, the exceeding power is sold through the public external power distribution grid or, under some circumstances, can be stored e.g. in storage batteries. Conversely, if the power generated by the PV panel installation is insufficient, power from the external power distribution grid is absorbed by the loads. It is therefore necessary to provide the inverter with circuitry suitable for determining the amount of power produced by the PV panels and delivered to the electric distribution grid. For this purpose, known inverters for PV panel installations are usually provided with a revenue grade meter (shortly RGM) to measure and record the energy produced by the inverter as well as other electric parameters of the AC grid voltage. The RGM is usually coupled to a wireless module for remote transmission of the collected data, e.g. to a remote control unit.

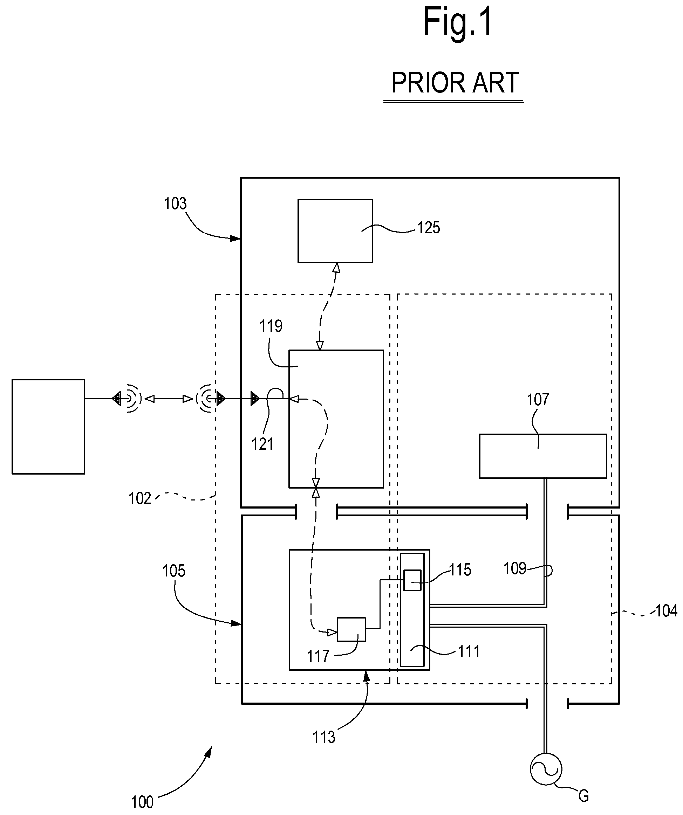

Fig.1 illustrates a block diagram of an inverter of the current art, with an RGM and a wireless communication module. The inverter 100 is provided with an inverter cabinet 103 and a switch box 105. In the inverter a so-called SELV Zone and an AC Grid Zone are provided. The SELV Zone is labeled 102 and the AC Grid Zone is labeled 104 in the block diagram of Fig.1. The SELV Zone is galvanically isolated from the AC Grid Zone and all the components therein are at a very low voltage (so-called Safety Extra Low Voltage), for safety reasons. The components in the AC Grid Zone can be at a higher voltage, e.g. at the voltage of the electric distribution grid G.

AC grid connectors, which connect the inverter 100 to the electric power distribution grid G, are arranged in the AC Grid Zone 104 and are schematically shown at 107. The AC grid connectors 107 are electrically coupled through a cable 109 to a sensing circuitry 111 which forms part of a revenue grade meter (RGM) block 113. The electric current at the output connectors 107 entirely flows through the sensing circuitry 111 of the revenue grade meter block 113. This latter is in the form of an add-on module, attached at the output AC grid connectors 107 of the inverter 100.

The electronics of the RGM block 113 is split into two portions, which are located in the AC Grid Zone and in the SELV Zone, respectively. The sensing circuitry 111 is in the AC Grid Zone, since the inverter output power flows there through. The block 111 containing the sensing circuitry also contains a logic measuring unit 115, which detects and measures the electric parameters required, such as the inverter output voltage and current, the active power and the reactive power. The logic measuring unit 115 is interfaced with a control unit or supervisor unit 117 for data processing. Measured parameters are then transmitted via a wireless module 119 and an antenna 121 to a wireless router 123. The wireless module 119 and the antenna 121 are both located in the SELV Zone 102.

The wireless module 119 is arranged in the inverter cabinet 103 and is connected to the inverter by means of connectors (not shown). The connectors provide power supply to the wireless module 119 as well as a communication channel between the wireless module 119 and an inverter supervisor 125.

The above described arrangement of the current art is cumbersome and expensive. Specifically, the need for a SELV zone 102 galvanically insulated from the AC grid zone 104, and a separation of the RGM electronics into two parts at two different voltage levels, entail high costs and manufacturing complexity. Moreover, the add-on sensing circuitry 111 and RGM block 113 is cumbersome.

There is thus a need for a simpler, less expensive and efficient arrangement of a RGM in an inverter, in particular for PV panel installations.

### Summary of the invention

According to some embodiments disclosed herein, an inverter is provided comprising at least an input for connection to an electric power source; grid connectors for connection to an electric power distribution grid; a metering device functionally coupled to a sensing circuitry arranged for sensing at least one electric parameter at the grid connectors and configured for measuring said at least one electric parameter. The metering device can be integrated with a data transmission arrangement.

The inverter can further include a sensing circuitry, functionally coupled to the metering device, configured and arranged to detect at least one electric parameter of an electric energy output of the inverter. The sensing circuitry can be is separate from the metering device, e.g. can be mounted on a power board of the inverter, electrically coupled to the grid connectors.

The metering device and the data transmission arrangement can be integrated on a same printed circuit board for maximum dimensional reduction.

In currently preferred embodiments, the data transmission arrangement is a wireless data transmission arrangement. For instance, the data transmission arrangement can be wired to an antenna, which is configured for data exchange with a data collection unit. This latter can be a wireless router.

Features and embodiments are disclosed here below and are further set forth in the appended claims, which form an integral part of the present description. The above brief description sets forth features of the various embodiments of the present invention in order that the detailed description that follows may be better understood and in order that the present contributions to the art may be better appreciated. There are, of course, other features of the invention that will be described hereinafter and which will be set forth in the appended claims. In this respect, before explaining several embodiments of the invention in details, it is understood that the various embodiments of the invention are not limited in their application to the details of the construction and to the arrangements of the components set forth in the following description or illustrated in the drawings. The invention is capable of other embodiments and of being practiced and carried out in various ways. Also, it is to be understood that the phraseology and terminology employed herein are for the purpose of description and should not be regarded as limiting.

As such, those skilled in the art will appreciate that the conception, upon which the disclosure is based, may readily be utilized as a basis for designing other structures, methods, and/or systems for carrying out the several purposes of the present invention. It is important, therefore, that the claims be regarded as including such equivalent constructions insofar as they do not depart from the spirit and scope of the present invention.

### Brief description of the drawings

A more complete appreciation of the disclosed embodiments of the invention and many of the attendant advantages thereof will be readily obtained as the same becomes better understood by reference to the following detailed description when considered in connection with the accompanying drawings, wherein:
Fig. 1 illustrates a block diagram of an inverter of the current art;
Fig.2 illustrates a schematic of a solar plant with photovoltaic panels and an inverter for connection to an electric power distribution grid;
Figs. 3 illustrates a block diagram of an embodiment of an inverter according to the present disclosure;
Figs. 4 and 5 illustrate block diagrams of further embodiments of an inverter according to the present disclosure;
Fig. 6 illustrates a schematic of a printed circuit board comprised of the RGM electronics;
Fig.7 illustrates a perspective external view of an inverter cabinet.

### Detailed description of embodiments

The following detailed description of exemplary embodiments refers to the accompanying drawings. The same reference numbers in different drawings identify the same or similar elements. Additionally, the drawings are not necessarily drawn to scale. Also, the following detailed description does not limit the invention. Instead, the scope of the invention is defined by the appended claims.

Reference throughout the specification to "one embodiment" or "an embodiment" or "some embodiments" means that the particular feature, structure or characteristic described in connection with an embodiment is included in at least one embodiment of the subject matter disclosed. Thus, the appearance of the phrase "in one embodiment" or "in an embodiment" or "in some embodiments" in various places throughout the specification is not necessarily referring to the same embodiment(s). Further, the particular features, structures or characteristics may be combined in any suitable manner in one or more embodiments.

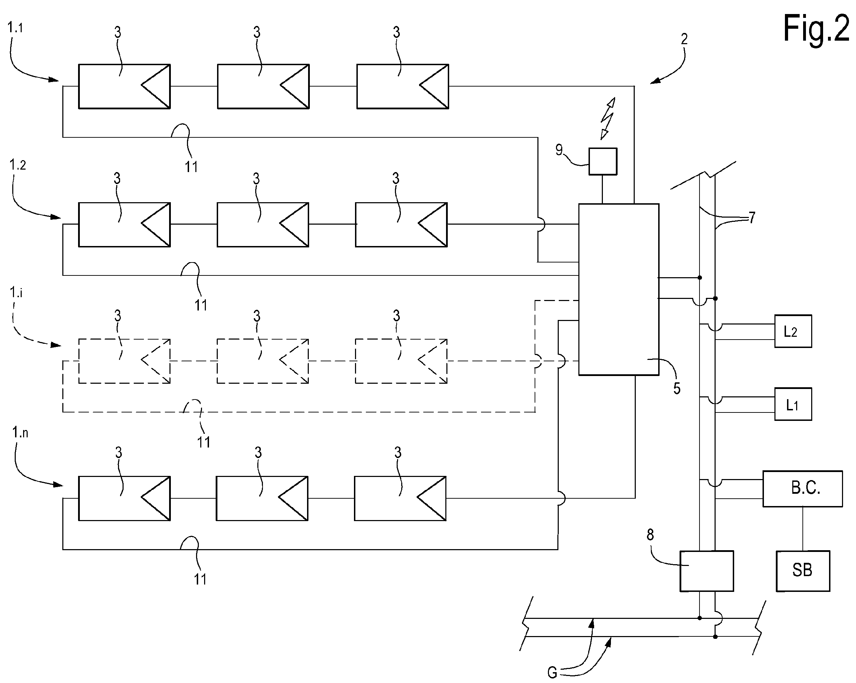

Fig.2 illustrates an exemplary embodiment of a photovoltaic installation 2 comprised of a plurality of photovoltaic panel strings 1.1, 1.2, ... 1.n. Each string 1.1, ..1.n comprises a plurality of serially arranged photovoltaic panels 3. The strings are electrically connected to an inverter 5. In other embodiments, each string can be provided with its own inverter. The inverter 5 converts the DC electric current generated by the photovoltaic panels 3 connected thereto into AC electric current, which is delivered to a local electric power distribution grid 7. Local loads schematically shown at L1 and L2 can be electrically coupled to the local electric power distribution grid 7 and can be powered by electric energy generated by the photovoltaic panels and/or by electric power from a public electric power distribution grid G. Reference number 8 indicates a meter which measures the power which flows from the public electric power distribution grid G to the local electric power distribution rid 7, or vice-versa.

A set of storage batteries SC and a battery charger BC can be provided and connected to the DC side of the inverter or to the AC side of the inverter (as shown in Fig.2), in order to store surplus electric power generated by the inverter 5. Depending upon the operating conditions of the loads L1, L2 and upon the solar energy actually collected by the photovoltaic panels 3, the photovoltaic installation 2 can produce sufficient power to supply the loads L1, L2, or less power than required by the loads. In the latter case electric power from the public electric power distribution grid G is absorbed.

In some operating conditions, the inverter can produce power exceeding the load needs, in which case the power in excess can be delivered to the external electric power distribution grid G, or partly or entirely stored in the storage batteries SB.

To determine the amount of power actually generated by the inverter 5, a revenue grade meter is integrated in the inverter 5 as will be described in greater detail here after. Electric operating parameters, in particular relating to the electric energy produced, can be transmitted remotely through a wireless router 9.

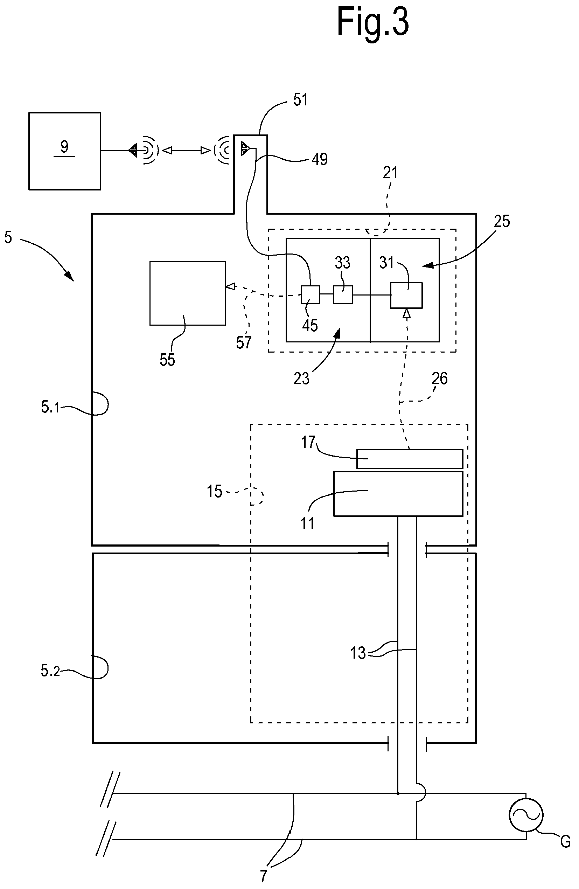

Fig.3 illustrates a block diagram of the inverter 5, limited to the components relating to the revenue grade meter and to the arrangement and operation thereof. The remaining components of the inverter 5 are known and do not require to be described here.

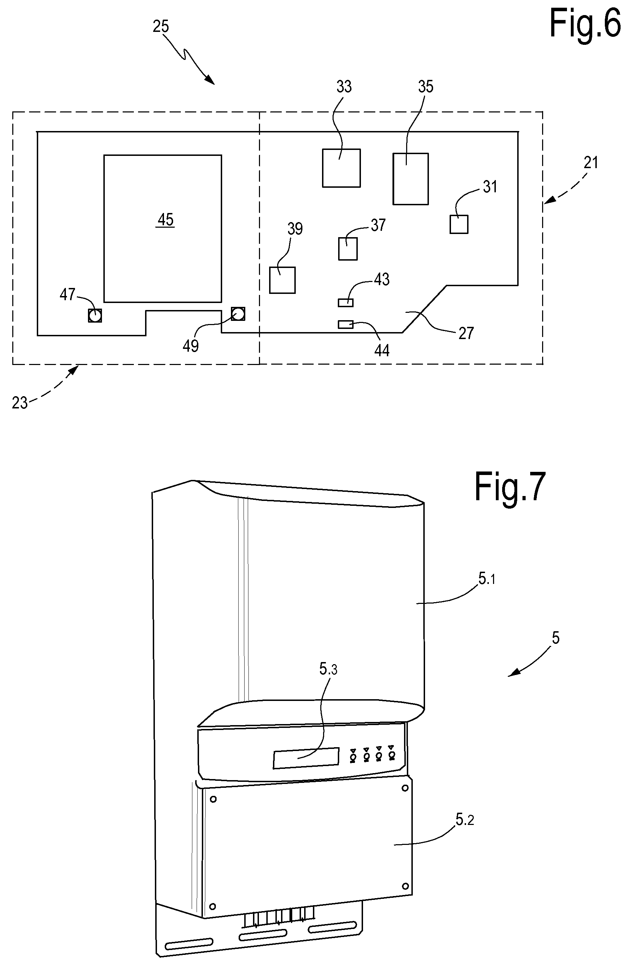

The inverter 5 can be comprised of an inverter cabinet 5.1 and can optionally be comprised of a switch box 5.2. Fig.7 illustrates a perspective external view of the inverter 5 and relevant cabinet 5.1. AC grid connectors 11 are arranged in the inverter cabinet 5.1 for connection to the grid 7 via cables 13. The AC grid connectors are arranged in an AC Grid Zone schematically shown at 15. In the AC Grid Zone a sensing circuitry 17 is also arranged, which is provided with sensor devices configured for detecting electric parameters of the current through the AC grid connectors 11 of the inverter 5. The sensing circuitry 17 can be integrated on a power board of the inverter and can be connected to the AC grid connectors 11. In some embodiments the sensor devices include a current sensing arrangement, e.g. using a shunt resistor, and a voltage measuring arrangement, e.g. using a voltage divider, not shown, to detect the electric current flowing through the AC grid connectors 11 and the voltage thereof. The sensing circuitry is integrated in the inverter and is arranged upstream of the AC grid connectors, such that no wiring to an external sensing circuitry is needed. Also, the actual electric current flowing through the AC grid connectors 11 does not require to flow through the sensing circuitry 17.

The inverter cabinet 5.1 further houses a metering device, here below also referred to as revenue grade meter (RGM) 21, and a data transmission arrangement 23. The data transmission arrangement may comprise a wireless radio module, e.g. based on ZigBee, WiFi or other wireless personal area network (WPAN) technology. The revenue grade meter 21 an the data transmission arrangement 23 can be integrated in a single RGM-transmission module globally labeled 25. The RGM-transmission module 25 can be mounted on a single printed circuit board 27, schematically shown in Fig.6.

The revenue grade meter 21 can be connected to the sensing circuitry 17 by means of a cable 26. The cable 26 can be connected to the terminals of a shunt resistor and to a voltage divider, in order to provide three voltage values to the revenue grade meter 21. The revenue grade meter 21 can comprise voltage sensors to measure the detected voltage values, and can further comprise a metrology chip 31, which is mounted on the printed circuit board 27 and connected to a meter supervisor 33. An insulator 35 can be provided on the printed circuit board 27, between the metrology chip 31 and the meter supervisor 33, to galvanically separate the two components, since the metrology chip is at a grid voltage.

Reference numbers 37 and 39 designate peripherals of the meter supervisor 33, such as memory chips. In some embodiments one memory can be used to store configuration parameters for the RGM and the electric energy meters. A second memory can be mounted when remote firmware updating via WPAN or Zigbee technology is desired.

According to some embodiments, the revenue grade meter 21 is further provided with one or preferably two LEDs 41, 43, which are controlled by the metrology chip 31 to provide a visual indication concerning one or more of the measured electric parameters. In some embodiments, the LEDs provide visual indication on the active power and reactive power flowing through the AC grid connectors 11. The metrology chip 31 can be configured by the meter supervisor 33 to cause the LEDs to blink at a frequency which is a function of the (active or reactive) power rate, such that the instant active and reactive power generated by the inverter 5 can be detected by measuring the blinking frequency of the LEDs 41, 43, respectively.

In some advantageous embodiments the LEDs 41, 43 are arranged such as to be visible from the outside of the inverter casing 5.1, e.g. through a window 5.3 (Fig.7). To this end the printed circuit board 27 can be mounted in the inverter cabinet 5.1 just behind the window 5.3. The instant operating conditions of the inverter can thus be easily detected without the need to access the interior of the inverter cabinet 5.1 or the switch cabinet 5.3.

On the printed circuit board 27 a transmission circuitry 45 can be mounted, which forms part of the data transmission arrangement 23. The transmission circuitry 45 can be a radio transmission circuitry for wireless transmission as described here after, and the data transmission arrangement 23 can thus be a wireless module.

According to some embodiments, one or more additional LEDs 47, 49 can be functionally coupled to the transmission circuitry 45, to provide visual indication on the actual operating conditions of the transmission arrangement 23. The LEDs 47, 49 can be arranged such as to be visible from the exterior of the inverter cabinet 5.1, e.g. through window 5.3 (Fig.7).

In the embodiment of Fig. 3 the data transmission arrangement 23 is connected to an antenna 49. The antenna 49 can be insulated e.g. by means of an electrically insulating shield 51 and can be arranged either inside the inverter cabinet 5.1 or partly or entirely outside the inverter cabinet 5.1, as schematically shown in Fig. 3. The antenna 49 receives data from the data transmission arrangement 23 and communicates wirelessly with the wireless router 9. This latter can be arranged outside the inverter cabinet 5.1, as schematically shown in Fig. 3. In other embodiments, e.g. if the antenna 49 is housed in the inverter cabinet 5.1, the wireless router 9 can be arranged inside the inverter cabinet 5.1 as well.

In other embodiments, not shown, a different data collection unit, different from a wireless router 9, can be provided, which can be in data communication through the antenna 49 with the inverter and which can transmit data to a remote control unit through a transmission channel, e.g. a wired channel.

An inverter control unit 55, referred to here after as inverter supervisor 55, can further be arranged in the inverter cabinet 5.1 and can be in data communication with the data transmission arrangement 23. In Fig.3 reference number 57 represents the data communication relationship. In some embodiments, the inverter control unit can be mounted on a printed circuit board, on which the RGM-transmission module 25 is mounted e.g. by means of a connector.

As can be understood by comparing the schematic of Fig. 3 with the schematic of Fig. 1, the arrangement according to the present disclosure results in substantial cost savings, due to a reduction of material and components required, and to simpler manufacturing, as well.

In particular, as far as the saving in terms of reduction of components and material is concerned, no cables are needed between the revenue grade meter 21 and the data transmission arrangement 23, since they are both mounted on the same printed circuit board. Additionally, while in the arrangement of Fig.1 the wireless module 119 is arranged in a SELV zone 102 and the inverter supervisor 125 is outside the SELV zone 102, which requires expensive galvanic insulation between the two components, in the arrangement according to the present disclosure no insulation is required between the inverter supervisor 55 and the data transmission arrangement 23. The entire circuitry and regulators needed on the SELV Zone side in the arrangement of Fig. 1 are dispensed with.

Additionally, the sensing circuitry 17 is integrated in the inverter and does not require additional AC connectors and cables as provided for in Fig.1. The connection between the revenue grade meter and the sensing circuitry 17 is through a small, polarized, inexpensive cable 26, internal to the inverter cabinet 5.1.

The reduced number of components results in simpler, faster and less expensive manufacturing.

Additional advantages are obtained with the embodiment disclosed in Figs. 3 and 6. Revenue grade applications require a re-calibration of the meter after a certain amount of service time (e.g. ten years), to compensate variations occurred. Having RGM's visual indicators (LEDs 41, 43) visible from the exterior of the inverter cabinet 5.1 allows recalibrating the RGM part directly on the field without opening the inverter cabinet, since the visual indicators are active parts of the calibration process itself. Additionally, the visual indicators visible from the exterior of the inverter cabinet 5.1 give an immediate feedback of the power produced by the inverter 5 in a straightforward manner.

The cost reduction achievable makes feasible to combine a revenue grade meter with a low cost wireless technology a (such as Zigbee) at an affordable price also for low-cost inverters. The customer can check remotely and in real time and with a high accuracy the energy produced (and so the revenue) by all his inverters connected to the wireless backbone, with a dedicated channel. This channel may be customer's proprietary or enciphered, for maximum trust.

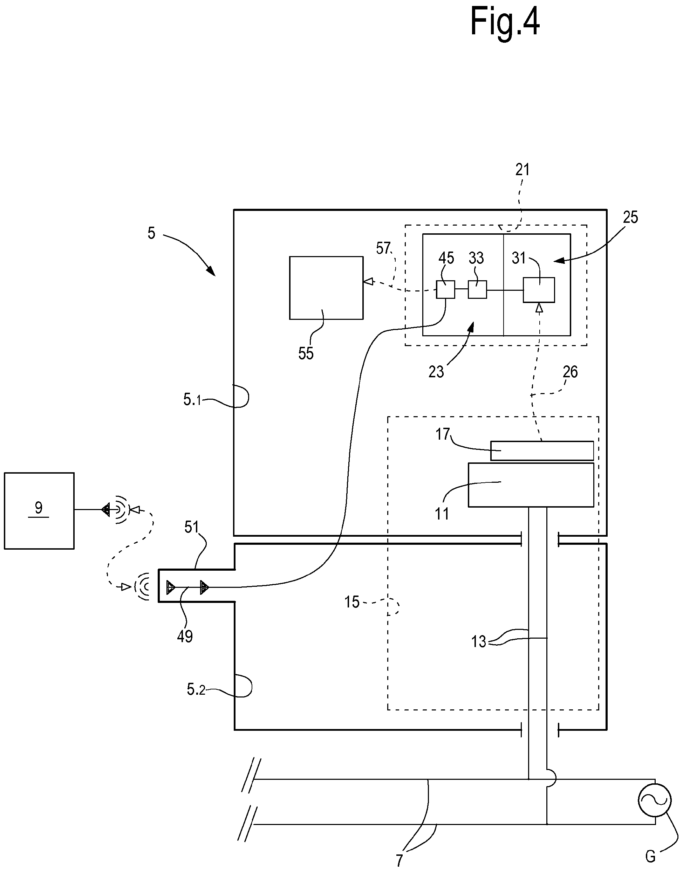

A further embodiment of an inverter 5 according to the present disclosure is shown in Fig.4. The same reference numbers used in Fig.3 designate the same or equivalent components or elements, which are not described again. The embodiment of Fig. 4 differs from the embodiment of Fig. 3 mainly in view of a different arrangement of the antenna 49. In Fig. 4 the antenna 49 and the insulating shield 51 thereof are arranged on the switch box 5.2 rather than on the inverter cabinet 5.1. In yet further embodiments, not shown, the antenna 49 can be arranged inside the switch box 5.2. The wireless router 9 can also be arranged inside the switch box 5.2.

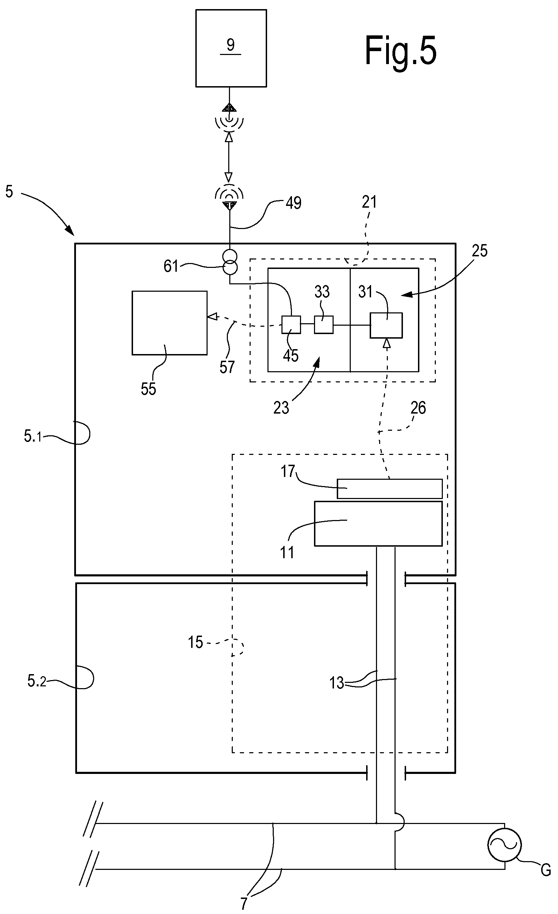

A yet further embodiment of the inverter 5 is shown in Fig.5. The same reference numbers designate the same or equivalent parts, elements or components as already disclosed in connection with Fig.3, and which will not be described again. In the embodiment of Fig. 5 a galvanic insulation 61 is provided along the data communication channel between the transmission circuitry 45 and the antenna 49, such that an insulating shield 51 can be dispensed with. A galvanically insulated antenna 49 can be used also in the embodiment of Fig. 4, with the antenna arranged in or on the switch box 5.2.

While the disclosed embodiments of the subject matter described herein have been shown in the drawings and fully described above with particularity and detail in connection with several exemplary embodiments, it will be apparent to those of ordinary skill in the art that many modifications, changes, and omissions are possible without materially departing from the novel teachings, the principles and concepts set forth herein, and advantages of the subject matter recited in the appended claims. For instance, a wired connection for data transmission can be used, rather than a wireless communication system. This is currently less preferred, since the wiring imply heavier installation costs. However the advantages mentioned above in terms of components and material cost reduction and manufacturing savings are maintained.

In yet further embodiments, the data from the data transmission arrangement 23 can be transferred to the inverter supervisor 55, and the latter can in turn be connected to a wired transmission system or to a wireless router 9 through an antenna such as the insulated antenna 49.

Hence, the proper scope of the disclosed innovations should be determined only by the broadest interpretation of the appended claims so as to encompass all such modifications, changes, and omissions. In addition, the order or sequence of any process or method steps may be varied or re-sequenced according to alternative embodiments.

## Claims

1. An inverter comprising:
- at least an input for connection to an electric power source (1.1; 1.2; 1.2; 3);
- grid connectors (11) for connection to an electric power distribution grid (7);
- a metering device (21) functionally coupled to a sensing circuitry (17) arranged for sensing at least one electric parameter at the grid connectors (11) and configured for measuring said at least one electric parameter;
wherein the metering device (21) is integrated with a data transmission arrangement (23).

2. The inverter of claim 1, further comprising a sensing circuitry (17), functionally coupled to the metering device (21), configured and arranged to detect at least one electric parameter of an electric energy output of the inverter, and wherein preferably said sensing circuitry (17) is separate from the metering device (21).

3. The inverter of claim 2, wherein the sensing circuitry (17) is mounted on a power board of the inverter, electrically coupled to the grid connectors (11).

4. The inverter of one or more of the preceding claims, wherein the metering device (21) and the data transmission arrangement (23) are integrated on a same printed circuit board (27).

5. The inverter of one or more of the preceding claims, wherein the data transmission arrangement (23) is a wireless data transmission arrangement.

6. The inverter of claim 5, wherein the data transmission arrangement (23) is wired to an antenna (49), which is configured for data exchange with a data collection unit (9).

7. The inverter of claim 6, wherein the data collection unit (9) is a wireless router.

8. The inverter of one or more of the preceding claims, wherein the at least one electric parameter is selected from the group consisting of: an output voltage at the grid connectors (11); an output current at the grid connectors (11); an active power flowing through the grid connectors (11); a reactive power flowing through the grid connectors (11).

9. The inverter of one or more of the preceding claims, wherein the metering device (21) is provided with visual indicators (41, 43) configured and controlled for providing a visual indication of at least one electric parameter measured by metering device (23).

10. The inverter of claim 9, wherein the visual indicators are visible from outside an inverter cabinet (5.1).

11. The inverter of claim 9 or 10, wherein the visual indicators comprise at least one LED (41; 43).

12. The inverter of claim 9, 10 or 11, wherein the visual indicators are configured and controlled to provide a blinking signal having a frequency which is proportional to at least one of an active power and a reactive power flowing through the grid connectors (11) of the inverter (5).
